# DEMANDE DE BREVET EUROPEEN

(11) **EP 4 177 944 A1**
(43) Date de publication de la demande: **10.05.2023**
(21) Numéro de dépôt: 22203460.5
(22) Date de dépôt: 25.10.2022
(51) Int. Cl.: H01L 23/427, H01L 21/48

(54) **CHAMBRE À VAPEUR**

(30) Priorité: 04.11.2021 FR 2111711
(71) Demandeur: Commissariat à l'Energie Atomique et aux Energies Alternatives, 75015 Paris (FR)
(72) Inventeur: COLONNA, Jean-Philippe, 38054 GRENOBLE CEDEX 09 (FR); COUDRAIN, Perceval, 38054 GRENOBLE CEDEX 09 (FR); FRECHETTE, Luc, SHERBROOKE, QC, J1J 2Y2 (CA); STRUSS, Quentin, 38000 GRENOBLE (FR)
(74) Mandataire: Cabinet Beaumont

(57) **Abrégé**

La présente description concerne un procédé de fabrication d'une chambre à vapeur (300) comprenant les étapes suivantes :
(a) graver, dans un premier substrat (301), au moins une première cavité (303) et au moins un canal (313) s'étendant à partir d'une face supérieure (305) dudit premier substrat (301), une première extrémité (315) dudit canal (313) débouchant dans ladite au moins une cavité (303) ;
(b) coller une face inférieure d'une plaque (309) à la face supérieure (305) dudit premier substrat (301), la plaque (309) comprenant au moins une première région en un matériau ductile (321) disposée en regard de ladite première extrémité (315) dudit canal (313) ;
(c) remplir ledit canal (313) avec un fluide de refroidissement (319) ; et
(d) fermer ladite cavité (303) en appliquant une pression sur ladite région en matériau ductile de la plaque (309) jusqu'à obstruer ladite première extrémité (315) dudit canal (313).

## Description

### Domaine technique

La présente description concerne de façon générale le refroidissement de systèmes, comme des systèmes mécaniques ou des systèmes électroniques. De façon plus particulière, la description concerne un dispositif de refroidissement de type "chambre à vapeur" et son procédé de fabrication.

### Technique antérieure

Beaucoup de systèmes, comme les systèmes mécaniques ou les systèmes électroniques, peuvent être sujets à des phénomènes de surchauffe susceptibles de les endommager ou d'endommager l'environnement dans lequel ils fonctionnent. Un moyen efficace de contrer les phénomènes de surchauffe est l'utilisation de dispositifs de refroidissement.

Il existe plusieurs types de dispositifs de refroidissement, comme les systèmes de climatisation, les caloducs, les chambres à vapeur, etc. Il est courant d'associer un dispositif de refroidissement à un système susceptible de surchauffe en le positionnant proche d'un point chaud du système.

Il serait souhaitable de pouvoir améliorer, au moins en partie, les inconvénients des dispositifs de refroidissement existants et de leurs procédés de fabrication.

### Résumé de l'invention

Il existe un besoin pour des dispositifs de refroidissement plus performants.

Il existe un besoin pour des chambres à vapeur plus performantes.

Il existe un besoin pour des procédés de fabrication de dispositifs de refroidissement plus performants.

Il existe un besoin pour des procédés de fabrication de chambres à vapeur mieux adaptés à la fabrication en série de chambres à vapeur.

Un mode de réalisation pallie tout ou partie des inconvénients des chambres à vapeur connus.

Un mode de réalisation pallie tout ou partie des inconvénients des procédés de fabrication connus de chambres à vapeur.

Un mode de réalisation prévoit Procédé de fabrication d'une chambre à vapeur (300) comprenant les étapes successives suivantes :
(a) graver, dans un premier substrat, au moins une première cavité s'étendant à partir d'une face supérieure dudit premier substrat , et au moins un canal à partir de la face supérieure dudit premier substrat , une première extrémité dudit canal débouchant dans ladite au moins une cavité ;
(b) coller une face inférieure d'une plaque à la face supérieure dudit premier substrat , la plaque comprenant au moins une première région en un matériau ductile disposée en regard de ladite première extrémité dudit canal ;
(c) remplir ledit canal avec un fluide de refroidissement ; et
(d) fermer ladite cavité en appliquant une pression sur ladite région en matériau ductile de la plaque jusqu'à obstruer ladite première extrémité dudit canal.

Selon un mode de réalisation, pendant l'étape (d), ladite première cavité est fermée hermétiquement.

Selon un mode de réalisation, le premier substrat est en un matériau choisi dans le groupe comprenant : un matériau semiconducteur, le silicium, un métal, un alliage métallique, le verre.

Procédé selon l'une quelconque des revendications 1 à 3, dans lequel, le matériau ductile est en un matériau polymère ou en un métal comme le cuivre, de l'argent, de l'aluminium, de l'or, ou un alliage de ces métaux.

Selon un mode de réalisation, pendant l'étape (a), des deuxièmes cavités sont gravées à partir de la face supérieure dudit premier substrat.

Selon un mode de réalisation, ledit canal relie ladite première cavité et lesdites deuxièmes cavités.

Selon un mode de réalisation, dans lequel les première et deuxièmes cavités sont reliées en série par ledit canal.

Selon un mode de réalisation, dans lequel les première et deuxièmes cavités sont reliées en parallèle par ledit canal.

Selon un mode de réalisation, dans lequel ladite plaque comprend une ouverture disposée au-dessus d'une première portion dudit canal.

Selon un mode de réalisation, la première portion du canal est une deuxième extrémité dudit canal.

Selon un mode de réalisation, dans lequel ledit canal comprend une troisième extrémité débouchant sur une ouverture en périphérie du premier substrat.

Selon un mode de réalisation, le procédé comprend, en outre, une étape (e) exécutée entre les étapes (b) et (c), pendant laquelle un quasi vide ou le vide est fait dans ladite au moins une première cavité.

Selon un mode de réalisation, ladite première région de ladite plaque s'étend sur toute la longueur de ladite plaque.

Selon un mode de réalisation, le liquide de refroidissement est choisi parmi le groupe comprenant : l'eau, l'hélium, l'hydrogène, l'oxygène, l'azote, le sulfure, le néon, l'argon, le méthane, le krypton, le mercure, l'ammoniaque (NH3), l'acétone (C3H6O), l'éthane (C2H6), le pentane (C5H12), l'heptane (C7H16), l'éthanol (C2H5OH), le méthanol (CH3OH), l'éthylène glycol (C2H6O2), le toluène (C7H8), le naphtalène (C10H8), le trichlorofluorométhane (CClL3F, aussi connu sous la dénomination commerciale Fréon 11), le dichlorofluorométhane (CHClL2F, aussi connu sous la dénomination commerciale Fréon 21), le chlorodifluorométhane (CHCIF2, aussi connu sous la dénomination commerciale Fréon 22), le 1,1,2-Trichloro-1,2,2-trifluoroéthane (C2CL3F3, aussi connu sous la dénomination commerciale Freon 113), le fluide connu sous la dénomination commerciale Flutec PP2, le fluide connu sous la dénomination commerciale Flutec PP9, le fluide connu sous la dénomination commerciale Dowtherm, le fluide connu sous la dénomination commerciale Novec, et les dérivés et mélanges de ces fluides.

Un autre mode de réalisation prévoit une chambre à vapeur fabriquée selon le procédé décrit précédemment.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente une vue en coupe et fonctionnelle, schématique, d'une chambre à vapeur associée à un dispositif électronique ;
la figure 2 représente une vue en coupe, schématique, d'un mode de réalisation d'une chambre à vapeur ;
la figure 3 représente trois vues de dessus, schématiques, de modes de réalisation de chambres à vapeur de la figure 2 ;
la figure 4 représente deux vues en coupe d'une partie d'une chambre à vapeur de la figure 2 ;
la figure 5 représente deux vues en coupe d'une autre partie d'une chambre à vapeur de la figure 2 ;
la figure 6 représente une vue de dessus illustrant schématiquement une variante de réalisation d'une chambre à vapeur de la figure 2 ;
la figure 7 représente trois vues en coupe illustrant des étapes d'un mode de mise en oeuvre d'un procédé de fabrication de chambres à vapeur de la figure 2 ;
la figure 8 représente trois vues en coupe illustrant d'autres étapes du mode de mise en oeuvre du procédé de la figure 7 ;
la figure 9 représente quatre vues en coupe illustrant d'autres étapes du mode de mise en oeuvre du procédé de la figure 7 ;
la figure 10 représente quatre vues en coupe illustrant des étapes d'un mode de mise en oeuvre d'un autre procédé de fabrication de la chambre à vapeur de la figure 2 ;
la figure 11 représente quatre vues en coupe illustrant des étapes d'un mode de mise en oeuvre d'encore un autre procédé de fabrication de chambres à vapeur de la figure 2 ;
la figure 12 représente deux vues en coupe illustrant des étapes d'un mode de mise en oeuvre d'encore un autre procédé de fabrication de la chambre à vapeur de la figure 2 ;
la figure 13 représente six vues en coupe illustrant des étapes d'un mode de mise en oeuvre d'un procédé de fabrication d'un système électronique ; et
la figure 14 représente deux vues en coupe illustrant d'autres étapes du mode de mise en oeuvre du procédé de la figure 13.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

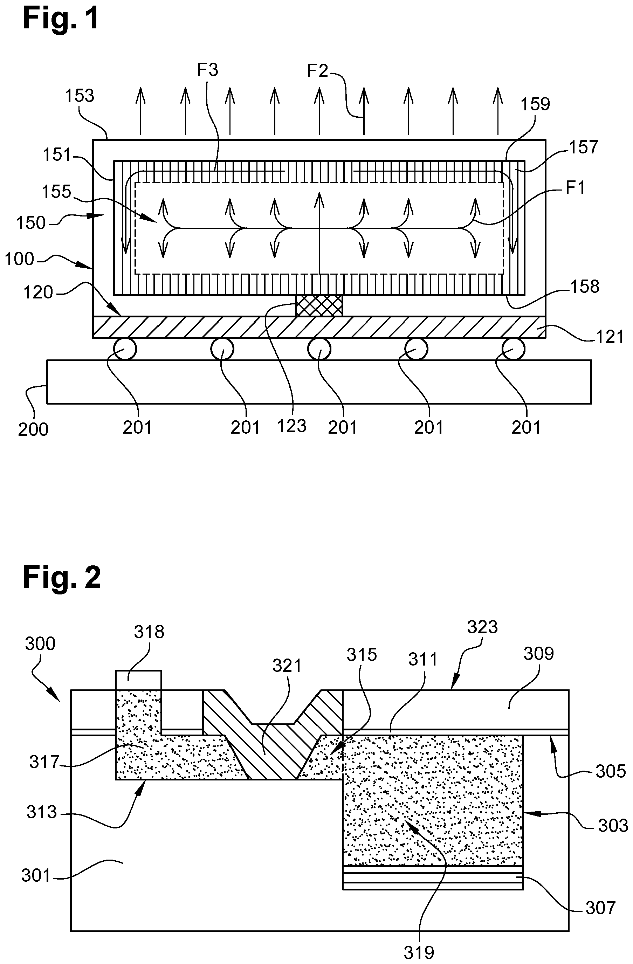

La figure 1 est une vue en coupe, fonctionnelle et schématique d'un système électronique 100 comprenant une chambre à vapeur 150.

Le système électronique 100 est monté sur un substrat 200, par exemple, par l'intermédiaire de billes de connexion 201. Le substrat 200 est, par exemple, un substrat massif, ou une carte de circuit imprimé, etc.

Le système électronique 100 est composé d'un dispositif électronique 120 et de la chambre à vapeur 150.

Le dispositif électronique 120 est quelconque, et peut comprendre tout ou partie d'un composant électronique, un ou plusieurs composants, un ou plusieurs circuits, par exemple un ou plusieurs circuits imprimés, etc. Ces composants sont représentés, en figure 1, par une couche 121. Le dispositif 120 comprend, en outre, un point chaud 123, c'est-à-dire une zone susceptible de dégager une forte chaleur, ou une zone susceptible de surchauffer. Ce point chaud peut correspondre à un composant, un ensemble de composants, un conducteur, etc. Le point chaud 123 est représenté, en figure 1, par un bloc 123.

La chambre à vapeur 150 comprend une cavité 151 formée dans un substrat 153. La cavité 151 est remplie d'un fluide 155 de refroidissement. Sur les parois de la cavité 151 est disposée une structure 157 de retour par capillarité.

La chambre à vapeur 150 est disposée de façon à aider au refroidissement du point chaud 123 du dispositif 120. Une face inférieure 158 de la cavité 151 est positionnée contre le point chaud 123 du dispositif électronique 120, cette face est appelée évaporateur. Une face supérieure 159 du dispositif électronique 120, opposée à la face 158, est appelée condenseur. La face supérieure 159 peut être accolée à un dissipateur thermique non représenté en figure 1.

Le fonctionnement de la chambre à vapeur 150 est le suivant. Au repos, c'est-à-dire lorsque le point chaud 123 ne dégage pas de chaleur, le fluide 155 est à l'équilibre entre sa phase gazeuse, ou phase vapeur, et sa phase liquide. Lorsque le point chaud 123 produit de la chaleur, le fluide 155 directement proche du point chaud 123 s'évapore, et créé un mouvement de vapeur au sein de la cavité 151. Plus particulièrement, le fluide 155 en phase vapeur s'éloigne de la face 158, par exemple en allant vers la face 159, ce qui est symbolisé, en figure 1, par une flèche F1. Une fois que le fluide 155 en phase vapeur atteint la face 159 de la cavité, il rencontre la structure 157 de retour par capillarité et se condense pour reprendre sa phase liquide. La chaleur est ainsi libérée du côté du condenseur, par exemple dans un dissipateur thermique. Ce phénomène est symbolisé par les flèches F2. La température du fluide 155 diminue alors et il retourne à sa position initiale en suivant les flèches F3.

La figure 2 est une vue en coupe d'un mode de réalisation d'une chambre à vapeur 300.

La chambre à vapeur 300 est formée dans un substrat 301. Selon un mode de réalisation, le substrat 301 est en un matériau semiconducteur, par exemple du silicium, ou est en un métal ou un alliage métallique, ou du verre. La chambre à vapeur 300 comprend une cavité 303 s'étendant depuis une face supérieure 305 du substrat 301. La cavité 303 a une profondeur inférieure à l'épaisseur du substrat 301, par exemple comprise entre 1 µm et 1 mm, de préférence entre 10 µm et 800 µm. Selon un exemple, la cavité 303 a, en vue de dessus, une forme sensiblement rectangulaire, par exemple sensiblement carrée, ayant une aire comprise entre 1 mm² et 10 cm². Un empilement de couches 307 est déposé au fond de la cavité 303 pour former une structure de retour par capillarité. Selon un exemple, la structure 307 de retour par capillarité est une structure appelée "mèche" pouvant comprendre des structures poreuses comme des rainures ou des mousses métalliques, comme des mousses en cuivre ayant des pores de dimension minimales de l'ordre de 1 µm. Selon un exemple, la structure de retour par capillarité peut être une structure poreuse fabriquée à partir d'un substrat, par exemple en cuivre ou en silicium, dans lequel sont formées des rainures, par exemple de largeur de l'ordre de 1 µm à 1 mm, et/ou des colonnes, par exemple de largeur de l'ordre de 1 µm à 1 mm. Le fond des cavités 303 est le condenseur de la chambre à vapeur 300.

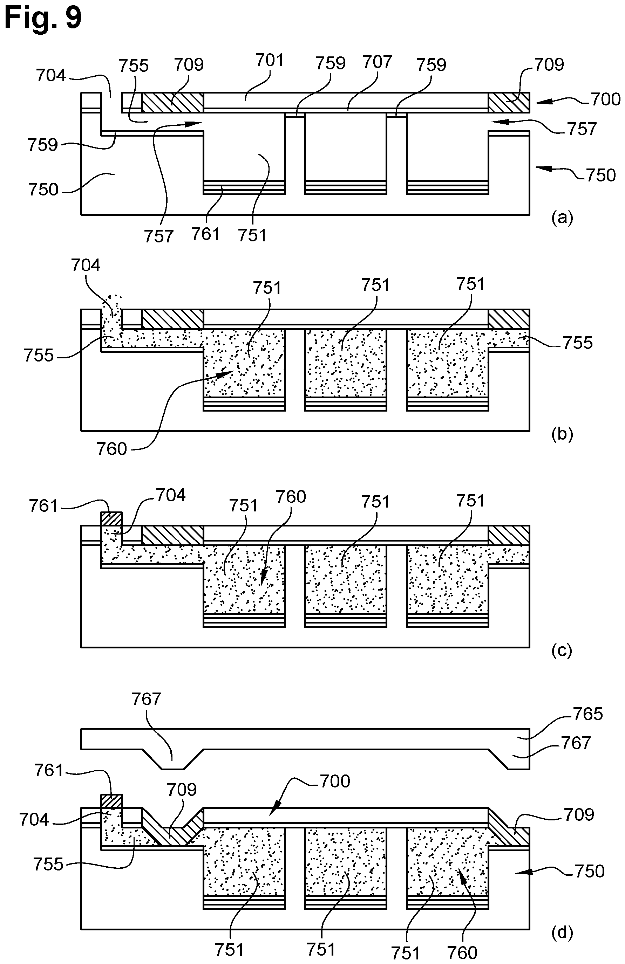

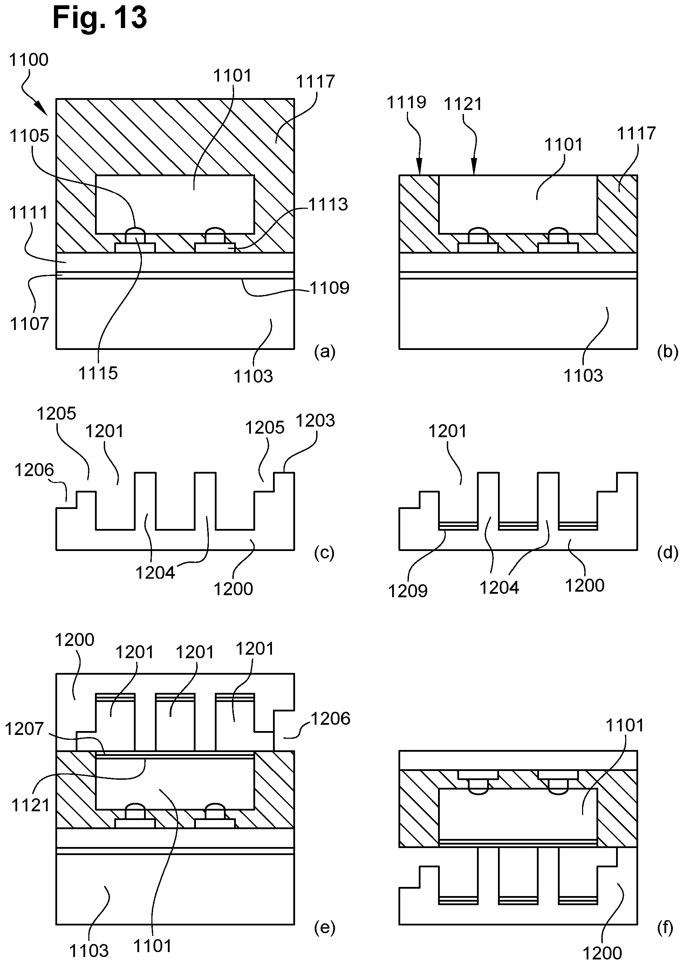

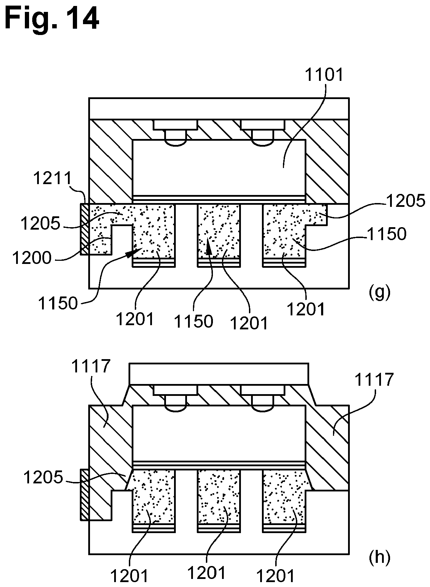

L'ouverture supérieure de la cavité 303 est fermée hermétiquement par une plaque 309. La plaque 309 est, par exemple, en le même matériau que le substrat 301, par exemple du silicium ou un métal. La plaque 309 est fixée, par exemple collée, au substrat 301. Selon un exemple, lorsque le substrat 301 et la plaque 309 sont en silicium, la face supérieure 305 du substrat 301 et la face inférieure de la plaque 309 sont oxydées pour effectuer un collage moléculaire à base d'oxyde de silicium. En figure 2, la zone de collage du substrat 301 et de la plaque 309 est représentée par une couche adhésive 311. D'autres exemples de procédé d'assemblage hermétique sont présentés en relation avec la figure 9. La plaque 309 forme l'évaporateur de la chambre à vapeur 300. Selon une variante, la plaque 309 peut être directement formée à partir d'un dispositif électronique à refroidir, un procédé de fabrication illustrant ce cas est décrit en relation avec les figures 13 et 14.

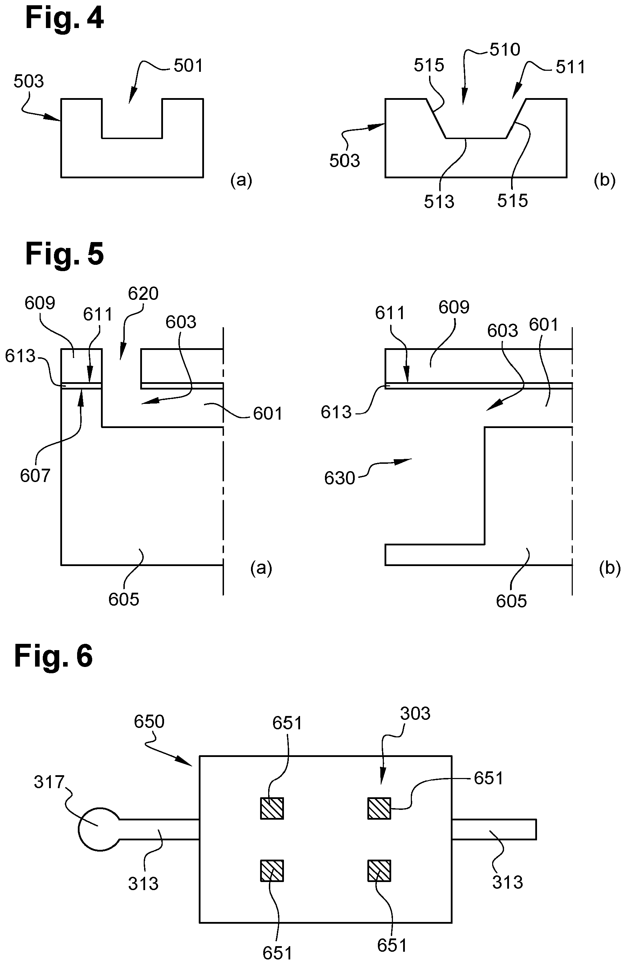

Selon un mode de réalisation, la chambre à vapeur 300 comprend, en outre, un canal 313 de remplissage de la cavité 303. Le canal 313 est une tranchée formée à partir de la face supérieure 305 du substrat 301. Selon un mode de réalisation, le canal 313 est moins profond que la cavité 303. Des exemples de formes en coupe du canal 313 sont décrites en relation avec la figure 4. Une première extrémité 315 du canal débouche sur la cavité 303, et une deuxième extrémité 317 du canal 313 est utilisée comme trou de remplissage. La deuxième extrémité, ou trou de remplissage, 317 est fermée par un bouchon 318. Le bouchon 318 peut être réalisé par queusotage. L'arrangement du trou de remplissage 317 est décrit plus en détails en relation avec la figure 5.

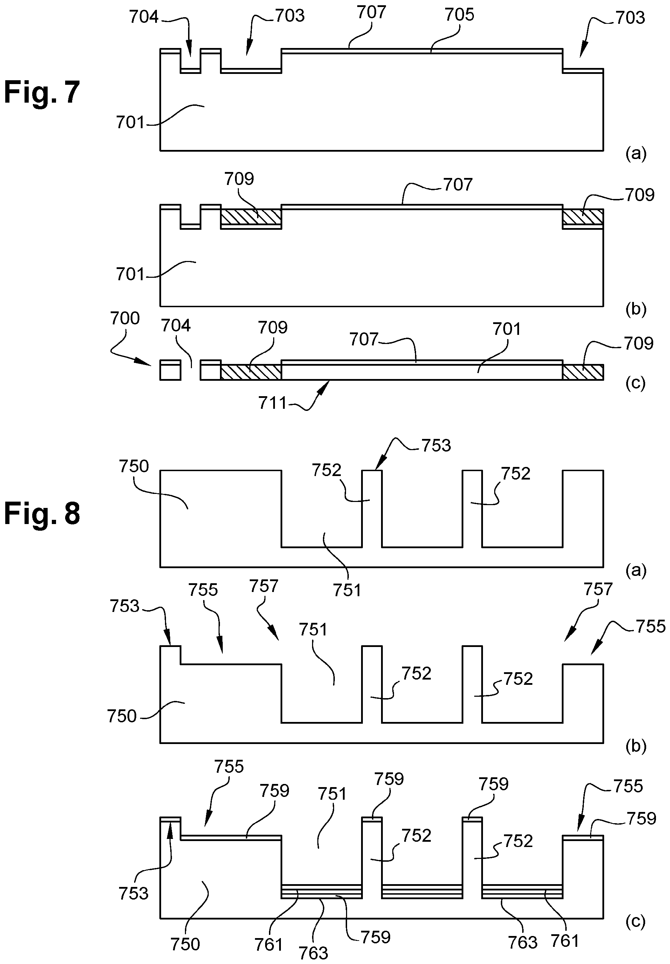

La cavité 303 est remplie d'un fluide de refroidissement 319. Le fluide 319 a été introduit dans la cavité 303 par le canal 313, et l'extrémité 315 a été scellée hermétiquement, après remplissage, par un matériau ductile 321 faisant partie de plaque 309. Le matériau ductile 321 peut être en un matériau polymère, comme une résine époxy, ou en un métal comme le cuivre, de l'argent, de l'aluminium, de l'or, ou un alliage de ces métaux. Des modes de mises en oeuvre de procédés de fabrication de la chambre à vapeur sont décrits en relation avec les figures 7 à 14.

Le fluide de refroidissement 319 est un fluide qui, à la température de repos de la chambre à vapeur 300, est à un équilibre entre sa phase liquide et sa phase gazeuse. Selon une variante, le fluide de refroidissement 319 peut être à l'équilibre entre sa phase liquide, sa phase gazeuse, et sa phase solide. On définit la température de repos de la chambre à vapeur 300, comme étant la température de fonctionnement normal du système à refroidir à laquelle la chambre à vapeur 300 est associée, c'est-à-dire la température de fonctionnement lorsque le système à refroidir n'est pas en train de surchauffer. Selon un mode de réalisation, le fluide de refroidissement 319 est choisi parmi le groupe, non exhaustif, comprenant : l'eau, l'hélium, l'hydrogène, l'oxygène, l'azote, le sulfure, le néon, l'argon, le méthane, le krypton, le mercure, l'ammoniaque (NH₃), l'acétone (C₃H₆O), l'éthane (C₂H₆), le pentane (C₅H₁₂), l'heptane (C₇H₁₆), l'éthanol (C₂H₅OH), le méthanol (CH₃OH), l'éthylène glycol (C₂H₆O₂), le toluène (C₇H₈), le naphtalène (C₁₀H₈), le trichlorofluorométhane (CCl₃F, aussi connu sous la dénomination commerciale Fréon 11), le dichlorofluorométhane (CHCl₂F, aussi connu sous la dénomination commerciale Fréon 21), le chlorodifluorométhane (CHCIF₂, aussi connu sous la dénomination commerciale Fréon 22), le 1,1,2-Trichloro-1,2,2-trifluoroéthane (C₂CL₃F₃, aussi connu sous la dénomination commerciale Freon 113), le fluide connu sous la dénomination commerciale Flutec PP2, le fluide connu sous la dénomination commerciale Flutec PP9, le fluide connu sous la dénomination commerciale Dowtherm, le fluide connu sous la dénomination commerciale Novec, et les dérivés et mélanges de ces fluides.

Un système à refroidir peut être associé à la chambre à vapeur 300 en étant positionnée, par exemple, sur une face supérieure 323 de la plaque 309, c'est-à-dire côté évaporateur.

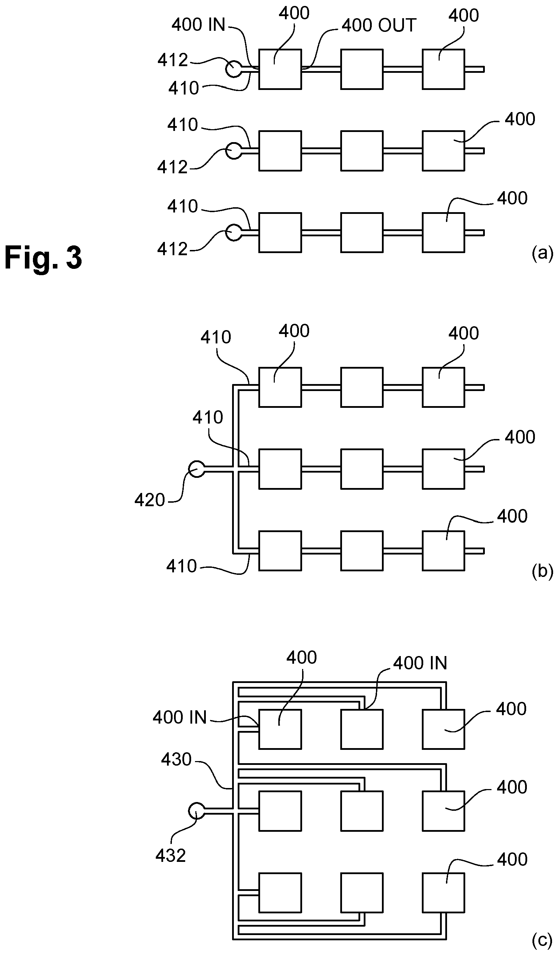

Les avantages de la chambre à vapeur 300 sont décrits en relation avec les figures 3 à 14.

La figure 3 représente trois vues de dessus (a), (b), et (c) de plusieurs chambres à vapeurs 400 du type de la chambre à vapeur 300 décrite en relation avec la figure 2.

Chaque vue (a), (b), (c) représente un exemple dans lequel neuf chambres à vapeur 400 sont formées simultanément dans un même substrat (non représenté sur les vues (a) à (c)). Il est évident qu'il est possible de former plus ou moins de neuf chambres à vapeur 400 simultanément en adaptant l'agencement de celle-ci. Les chambres à vapeur 400 sont disposées en trois lignes et trois colonnes. Les chambres à vapeur 400 sont remplies simultanément en étant connectées à des canaux de remplissage communs. Les vues (a) à (c) présentent différents modes de réalisation de canaux de remplissage communs. Plus particulièrement, les vues (a) et (b) présentent des modes de réalisation dans lesquelles les chambres à vapeur 400 sont reliées "en série", et la vue (c) représente un mode de réalisation dans lequel les chambres à vapeur 400 sont reliées "en parallèle".

La vue (a) représente un mode de réalisation dans lequel toutes les chambres à vapeur 400 d'une même ligne sont reliées "en série" par un même canal de remplissage 410. Plus particulièrement, chaque chambre à vapeur 400 comprend une entrée 400IN et une sortie 400OUT chacune reliée au canal 410 de remplissage. Chaque chambre à vapeur 400 est reliée à la suivante par le canal de remplissage 410. Chaque canal de remplissage est terminé par un trou de remplissage 412. Autrement dit, dans le mode de réalisation représenté en vue (a), trois chambres à vapeurs 400 sont reliées d'une même ligne par un même canal de remplissage 410, et ces trois chambres à vapeur 400 sont remplies d'un fluide de refroidissement par un même trou de remplissage 412.

Selon une variante, toutes les chambres à vapeur d'une même colonne pourraient être reliées "en série" de la même façon.

La vue (b) représente un mode de réalisation, similaire à celui représenté en vue (a), dans lequel toutes les chambres à vapeur 400 d'une même ligne sont reliées "en série" par un même canal de remplissage 410. A la différence du mode de réalisation de la vue (a), les canaux 410 sont tous reliés à un trou de remplissage 420 commun à tous les canaux. Autrement dit, dans le mode de réalisation représenté en vue (b), trois chambres à vapeurs 400 sont reliées par un même canal de remplissage 410, et les neuf chambres à vapeurs 400 sont remplies d'un fluide de refroidissement par un même trou de remplissage 420.

Selon une variante, toutes les chambres à vapeur d'une même colonne pourraient être reliées "en série" de la même façon.

La vue (c) représente un mode de réalisation dans lequel toutes les chambres à vapeur 400 sont reliées "en parallèle" par un canal de remplissage 430. Plus particulièrement, les chambres à vapeur 400 ne comprennent qu'une seule entrée 400IN reliée au canal de remplissage 430. Le canal de remplissage 430 est relié à un seul trou de remplissage 432. Ainsi, les neufs chambres à vapeur 400 sont reliées par un même canal de remplissage 430, et sont remplies d'un fluide de refroidissement par un même trou de remplissage 432.

Un avantage des modes de réalisation présentées en figure 3, est que plusieurs chambres à vapeur peuvent être formées et remplies de fluide de refroidissement simultanément. Une fois les chambres à vapeur remplies, les canaux de remplissage sont scellés, et les chambres à vapeur peuvent être individualisées, en utilisant, par exemple, des procédés de découpe à la scie.

La figure 4 représente deux vues (a) et (b) en coupe d'un canal de remplissage d'une cavité d'une chambre à vapeur du type du canal de remplissage 313 décrit en relation avec la figure 2 ou des canaux 410 et 430 décrits en relation avec la figure 3. Les vues (a) et (b) illustrent différentes formes pouvant être utilisées pour former un canal de remplissage d'une cavité d'une chambre à vapeur.

La vue (a) représente un canal de remplissage 501 formé dans un substrat 503. Le canal de remplissage 501 a, en coupe transversale, une forme rectangulaire, ou par exemple carrée.

La vue (b) représente un mode de réalisation préféré d'un canal de remplissage 510 formé dans le substrat 503. Le canal de remplissage 501 a, en coupe transversale, une forme trapézoïdale. Plus particulièrement, le canal 510 a une ouverture supérieure 511 de largeur supérieure à la largeur de son fond 513. Ainsi, les parois 515 du canal 510 ne sont pas verticales mais inclinées.

Les canaux 501 et 510 sont formés en utilisant une étape de masquage, par exemple par lithographie, puis une étape de gravure du substrat 503. Selon un exemple, la profondeur des canaux 501 et 510 peut être comprise, par exemple, entre 1 µm et 1 mm, par exemple entre 10 et 800 µm.

La figure 5 représente deux vues (a) et (b) en coupe d'un trou de remplissage d'une cavité d'une chambre à vapeur du type du trou de remplissage 317 décrit en relation avec la figure 2 ou du type des trous de remplissage 412, 420 et 432 décrits en relation avec la figure 3.

Les vues (a) et (b) représentent une vue partielle d'une chambre à vapeur du type de celle décrite en relation avec la figure 2. Les vues (a) et (b) représentent, plus précisément, une extrémité 603 d'un canal de remplissage 601 formé dans un substrat 605. Une face supérieure 607 du substrat 605 est collée à la face inférieure 611 d'une plaque 609 comme décrit en relation avec la figure 2, ce qui est représentée par une couche adhésive 613.

La vue (a) représente un mode de réalisation d'un trou de remplissage 620 "vertical" auquel est reliée l'extrémité 603 du canal de remplissage 601. Plus particulièrement, le trou de remplissage 620 est formé dans la plaque 609, et est disposé au-dessus de l'extrémité 603 pendant le collage de la plaque 609 sur le substrat 605. Comme cela est illustré en figure 5, le trou de remplissage 620 peut avoir des dimensions similaires aux dimensions du canal de remplissage 601, ou le trou de remplissage 620 peut être plus large que le canal 601. Selon un exemple, le trou 620 peut être réalisé avant ou après collage de la plaque 609 sur le substrat 601.

La vue (b) représente un mode de réalisation d'un trou de remplissage 630 "horizontal" auquel est reliée l'extrémité 603 du canal de remplissage 601. Plus particulièrement, le trou de remplissage 630 est formé dans le substrat 605 et débouche sur le bord latéral du substrat 605. Le trou de remplissage 630 peut avoir des dimensions similaires aux dimensions du canal de remplissage 601, ou, comme cela est illustré en figure 5, le trou de remplissage 630 peut être plus large que le canal 601. Selon un exemple, le trou 630 peut être réalisé en fin de procédé de fabrication, par exemple, par une étape de découpe à la scie.

La figure 6 est une vue de dessus, schématique et simplifiée, représentant un mode de réalisation d'une chambre à vapeur 650.

La chambre à vapeur 650 est une variante de la chambre à vapeur 300 décrite en relation avec la figure 2. Les chambres à vapeur 300 et 650 ont des éléments communs, seules leurs différences sont mises en exergue ici. En figure 6, sont représentés les éléments suivants de la chambre à vapeur 650 :
- la cavité 303 ;
- le canal 313 de remplissage ; et
- le trou 317 de remplissage.

La chambre à vapeur 650 diffère de la chambre à vapeur 300 en ce qu'elle comprend des piliers de soutien 651, ou piliers 651, disposés dans la cavités 303 permettant d'aider à la tenue mécanique de la plaque 309 (non représentée en figure 6) sur la cavité 303. En figure 6, quatre piliers 651 sont représentés. La personne du métier saura ajuster le nombre et l'emplacement des piliers 651 pour optimiser la tenue de la plaque 309 sur la cavité 303. De plus, en figure 6, les piliers ont été représentés comme ayant une forme de poutre à section sensiblement carrée, mais, selon un autre exemple, les piliers 651 pourraient être de section sensiblement rectangulaire ou sensiblement circulaire. De plus, les piliers 651 peuvent être aussi recouverts par la structure de retour par capillarité. Les piliers 651 sont, par exemple, en un même matériau que celui du substrat dans lequel est formée la cavité 303.

Les figures 7 à 9 représentent des vues en coupe illustrant des étapes d'un mode de mise en oeuvre d'un procédé de fabrication de trois chambres à vapeur du type de la chambre à vapeur 300 décrite en relation avec la figure 2. Plus particulièrement, la figure 7 représente trois vues en coupe (a), (b) et (c) illustrant des étapes de préparation d'une plaque du type de la plaque 309 décrite en relation avec la figure 2. La figure 8 représente trois vues en coupe (a), (b) et (c) illustrant des étapes de préparation d'un substrat du type du substrat 301 décrit en relation avec la figure 2. La figure 9 représente quatre vues en coupe (a), (b), (c) et (d) illustrant des étapes de réalisation des chambres à vapeur du type de celle décrite en relation avec la figure 2 par assemblage de la plaque de la figure 7 et du substrat de la figure 8.

Comme dit précédemment, la figure 7 illustre des étapes de préparation d'une plaque 700 du type de la plaque 309 décrite en relation avec la figure 2.

La vue (a) de la figure 7 illustre la formation, dans un substrat 701, de cavités 703 et 704. Sur la vue (a), une cavité 704 est représentée et deux cavités 703 sont représentées. Selon un exemple, le substrat 701 est, par exemple, en un matériau semiconducteur, par exemple un matériau comprenant du silicium. Les cavités 703 et 704 s'étendent à partir d'une face supérieure 705 du substrat 701. Les cavités 703 sont destinées à être remplies de matériau ductile, et la ou les cavités 704 sont destinées à former des trous de remplissage verticaux du type de celui décrit en relation avec la figure 5. En vue de dessus, les cavités 703 sont plus larges que les canaux de remplissage de la chambre à vapeur. Selon une variante de réalisation, la ou les cavités 704 peuvent ne pas être formées à cette étape, mais après l'assemblage avec le substrat décrit en relation avec la figure 9. Selon une autre variante de réalisation, lorsque les chambres à vapeur utilisent un ou plusieurs trous de remplissage dit horizontaux, comme décrit en relation avec la figure 5, la ou les cavités 704 ne sont pas formées.

Selon un exemple, les cavités 703 et 704 sont formées en utilisant une étape de masquage, par exemple une étape de lithographie comme une étape de photolithographie, puis une étape de gravure des parties non masquées, par exemple en utilisant un procédé de gravure humide, ou un procédé de gravure sèche, comme une gravure ionique réactive sèche (DRIE pour Dry Reactive-Ion Etching).

La vue (a) illustre, en outre, la formation, optionnelle, d'une couche adhésive 707 sur la face supérieure 705 du substrat 701. Selon un exemple, la formation d'une couche adhésive peut être un dépôt de la couche adhésive, par exemple un dépôt par jet d'encre. Selon un autre exemple, si le substrat 705 est en silicium, la formation de la couche adhésive peut être une étape d'oxydation de la surface du substrat pour préparer une étape de collage moléculaire.

La vue (b) illustre une étape de dépôt d'un matériau ductile 709 dans les cavités 703. Le matériau ductile 709 peut être une résine, un polymère, un métal, du verre fusible, ou bien une combinaison ou un empilement de plusieurs de ces éléments. Le procédé de dépôt du matériau ductile 709 dépend de la nature du matériau ductile. Selon un exemple, le procédé de dépôt peut comprendre une ou plusieurs étapes de recuit. De même, l'épaisseur de matériau ductile 709 dépend aussi de la nature du matériau ductile.

Selon un exemple, le matériau ductile 709 peut comprendre une résine époxy, comme une résine époxy chargée. Dans ce cas, des procédés de type laminage peuvent être utilisés, comme un procédé WOLM (Wafer Level Over Molding) . L'étape de dépôt peut être suivie par une étape de recuit, par exemple un recuit de polymérisation. Le matériau ductile 709 peut avoir une épaisseur maximale de l'ordre de 500 µm, par exemple de 300 µm.

Selon un autre exemple, le matériau ductile 709 peut comprendre du cuivre, de l'argent, de l'aluminium, de l'or, un alliage de métaux utilisé pour les soudures, etc. Dans ce cas, le procédé de dépôt peut être un dépôt électrolytique, une sérigraphie de pâte métallique, un procédé de dépôt en phase vapeur, etc. L'étape de dépôt peut être suivie par une étape de recuit. Le matériau ductile 709 peut avoir une épaisseur maximale de l'ordre de 100 µm.

Pour que le matériau ductile 709 ne soit déposé que dans les cavités 703, le reste de la structure de la vue (a) peut être masquée. Selon une variante, le matériau ductile 709 peut être déposé sur toute la structure de la vue (a) puis retiré des zones où il n'est pas utile. Dans ce cas, le matériau ductile peut être retiré par exemple par un procédé de polissage.

La vue (c) illustre une étape d'amincissement de la structure de la vue (b) pour obtenir la plaque 700. La structure de la vue (b) est amincie par une face arrière 711 du substrat 701 jusqu'à atteindre le fond des cavités 703 et 704 de façon à laisser apparent le matériau ductile 709. Le procédé d'amincissement est par exemple un procédé de meulage. On a ainsi formé la plaque 700. La plaque 700 peut avoir une épaisseur comprise entre 50 µm et 50 mm. Selon un exemple, si la plaque 700 est en silicium, son épaisseur est comprise entre 500 µm et 1 mm.

Comme dit précédemment, la figure 8 illustre des étapes de préparation d'un substrat 750 du type du substrat 301 décrite en relation avec la figure 2.

La vue (a) illustre une étape de gravure de cavités 751 dans le substrat 750. L'étape de gravure des cavités 751 peut comprendre une étape de masquage puis une étape de gravure du substrat 750, comme une étape de gravure Bosch. Selon un mode de réalisation, une cavité 751 est formée dans le substrat 750, la cavité 751 étant destinée à former une chambre à vapeur. La cavité 751 s'étend depuis une face supérieure 753 du substrat 750. Selon un exemple de réalisation, les cavités 751 peuvent avoir une profondeur comprise entre 5 µm et 1 mm, de préférence comprise entre 60 et 500 µm.

Par ailleurs, des piliers 752 sont formés dans la cavité 751. Deux piliers 752 sont représentés sur les vues de la figure 8. Les piliers 752 sont du même type que les piliers 651 décrits en relation avec la figure 6. Les piliers 752 sont, par exemple, formés par masquage lors de la gravure de la cavité 751.

La vue (b) illustre une étape de gravure d'un canal de remplissage 755 dans le substrat 750. Le canal de remplissage 755 a au moins une extrémité 757 qui débouche sur la cavité 751. Le canal 755 a, en vue de dessus, une forme similaire à celles décrites en relation avec la figure 3. L'étape de gravure du canal 755 peut comprendre une étape de masquage puis une étape de gravure du substrat 750, comme une étape de gravure Bosch. Le canal 755 s'étend depuis la face supérieure 753 du substrat 750. Le canal 755 a une profondeur inférieure à la profondeur de la cavité 751. Le canal a, préférentiellement une profondeur plus petite que leur largeur en vue de dessus, par exemple avec un rapport largeur-profondeur compris entre 1 et 10. Le canal 755 a une profondeur comprise entre 10 et 200 µm. Le canal 755 a une largeur comprise entre 10 et 500 µm.

La vue (c) illustre la formation, optionnelle, d'une couche adhésive 759 sur la face supérieure 753 du substrat 701 obtenu en vue (b). Selon un exemple, la formation d'une couche adhésive peut être un dépôt de la couche adhésive. Selon un autre exemple, si le substrat 750 est en silicium, la formation de la couche adhésive peut être une étape d'oxydation de la surface du substrat pour préparer une étape de collage moléculaire.

La vue (c) illustre, en outre, la formation d'une structure 761 de retour par capillarité dans le fond 763 de la cavité 751. Selon un exemple, la structure 761 de retour par capillarité est formée en utilisant un procédé de gravure Bosch de pilier ou de tranchées utilisant une lithographie et une gravure. Selon une variante de réalisation, la structure 761 de retour par capillarité peut être formée à une étape de gravure commune avec la gravure des canaux 755.

Le substrat 750 est ainsi prêt pour son assemblage à la plaque 700 décrite en vue (c) de la figure 7.

Comme dit précédemment, la figure 9 illustre la réalisation d'étapes de fabrication de chambres à vapeur du type de celle décrite en relation avec la figure 2 en assemblant la plaque 700 de la figure 7 et le substrat 750 de la figure 8.

La vue (a) illustre le positionnement de la plaque 700 de la vue (c) de la figure 7 sur le substrat 750 de la vue (c) de la figure 8. Plus particulièrement, la plaque 700 est retournée, de façon à avoir la couche adhésive 707 en regard de la couche adhésive 759 du substrat 750. La plaque 700 est positionnée au-dessus du substrat de façon que les portions de matériau ductile 709 sont disposés en regard d'une extrémité 757 du canal 755 débouchant sur la cavité 751 du substrat 750, et que les cavités 704 sont disposées en regard d'une autre extrémité du canal 755 destinée à être reliée à un trou de remplissage. La plaque 700 et le substrat 750 sont alignés l'un en regard de l'autre avec une précision maximale de l'ordre de 1 µm.

La vue (a) illustre, en outre, le collage de la plaque 700 sur le substrat 750. Le procédé de collage utilisé ici dépend de la nature des couches adhésives 707 et 759. Selon un exemple, le collage peut être un collage direct, un collage direct hydrophile, un collage moléculaire, un collage polymère, un collage utilisant du verre fritté, un scellement eutectique, un collage par thermocompression, etc. Le procédé de collage peut comprendre des étapes de polissage, des recuits, des mises sous pression ou sous vide. Un procédé ne nécessitant pas de couches adhésives peut aussi être utilisés.

La vue (b) illustre une étape de remplissage de la cavité 751 avec un fluide de refroidissement 760 du type du fluide de refroidissement 319 décrit en relation avec la figure 2. Le procédé de remplissage utilisé à cette étape est le suivant :
- retirer les gaz présents dans la cavité 751 ;
- introduire le fluide de refroidissement 760 dans la cavité 751.

Les gaz présents dans la cavité 751 sont retirés en effectuant une mise sous vide, ou sous un quasi-vide, de la cavité 751, en la reliant à une pompe à vide. La mise sous-vide peut être suivie d'un dégazage à chaud des parois de la cavité 751 permettant de retirer les espèces chimiques résiduelles pouvant être absorbées par le matériau du substrat 750.

L'introduction du fluide de refroidissement 760 est réalisée par injection du volume précis du fluide 760 nécessaire pour remplir la cavité 751. Le fluide 760 peut être dégazé avant son introduction. Le fluide 760 est, plus particulièrement, introduit dans la cavité 704 de la plaque 700, puis passe dans le canal 755 pour remplir la cavité 751.

La vue (c) illustre une étape de fermeture de la cavité 704. Le remplissage de la cavité 751 est terminé, et les trous de remplissage, c'est-à-dire les cavités 704, sont fermés hermétiquement, par exemple, par un bouchon 761 installé par queusotage.

La vue (d) illustre une étape de scellement du canal 755 et de la cavité 751. Cette étape de scellement consiste en l'écrasement du matériau ductile 709 dans le canal 755 pour remplir une portion du canal 755 de matériau ductile 709, et ainsi fermer l'accès de la cavité 751. Cette étape peut, en pratique, être réalisée de plusieurs manières, par exemple, par thermocompression du matériau ductile 709, par pressage à l'aide d'un moule, etc. En figure 9, le procédé utilisé est un pressage à l'aide d'un moule 765. La force de pression maximale pouvant être utilisée est de l'ordre de 100 kN. Selon un exemple, le moule 765 peut être fabriqué à partir d'un substrat en le même matériau que le substrat 750, par exemple, en silicium, ou en un métal. Le moule 765 peut être le résultat d'une succession d'étapes de masquage, de gravure, et de polissage, par exemple par nano-impression. Plus particulièrement, le moule comprend des reliefs 767 disposés en regard des portions de la plaque 700 en matériau ductile 709. Les reliefs 767 peuvent avoir une section transversale rectangulaire ou trapézoïdale.

Selon un variante, pour améliorer l'étanchéité du scellement du canal 755, les parois du canal 755 peuvent être traitées au préalable avec un matériau promoteur d'adhérence comme le hexaméthyldisilazane (HDMS), ou bien en déposant sur les parois une couche d'accroche, par exemple, en un alliage de titane et de cuivre.

On obtient ainsi, en fin de procédé, une chambre à vapeur du type de la chambre à vapeur 300 décrite en relation avec la figure 2.

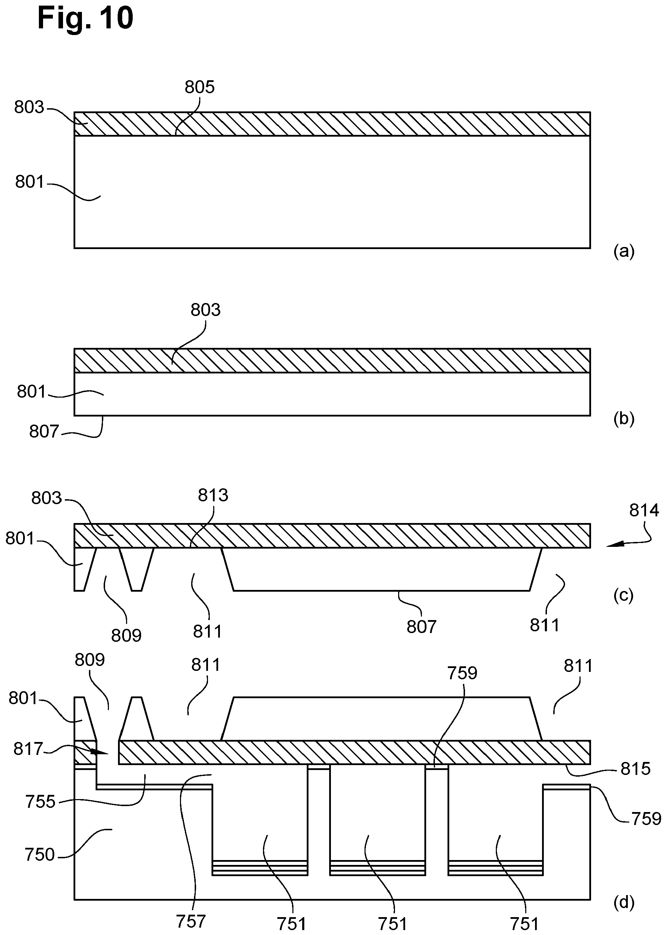

La figure 10 représente quatre vues (a), (b), (c), et (d) en coupe illustrant des étapes d'une variante du procédé de fabrication décrit en relation avec les figures 7 à 9. Plus particulièrement, les vues (a) à (d) illustrent une variante de mise en oeuvre du procédé de fabrication de la plaque 700 décrite en relation avec la figure 7, et son assemblage au substrat 750 décrit en relation avec la figure 8.

La vue (a) illustre une étape de dépôt, sur un substrat 801, d'une couche 803 en un matériau ductile. La couche 803 est déposée, plus particulièrement, sur une face supérieure 805 du substrat 801 et recouvre complètement cette face supérieure 805, on parle alors d'un dépôt pleine plaque. Le substrat 801 est, par exemple, en un matériau semiconducteur, par exemple, un matériau comprenant du silicium. La couche 803 est en un matériau ductile du type du matériau ductile 709 décrit en relation avec la figure 7, et son procédé de dépôt dépend de la nature du matériau ductile. La couche 803 a une épaisseur, par exemple, comprise entre 20 et 200 µm.

La vue (b) illustre une étape d'amincissement du substrat 801 par sa face arrière 807. Le procédé d'amincissement est par exemple un procédé de meulage. L'épaisseur du substrat 801 peut alors être inférieure à 200 µm.

La vue (c) illustre la gravure de cavités 809 et 811 dans le substrat 801. Sur la vue (c), une cavité 809 est représentée et deux cavités 811 sont représentées. Les cavités 809 et 811 sont gravées à partir de la face arrière 807 du substrat 801 et jusqu'à une face 813 inférieure de la couche 803. Les cavités 809 sont destinées à devenir des trous de remplissage, comme les cavités 704 de la figure 7. Comme les cavités 704 de la figure 7, les cavités 809 peuvent ne pas être formées à cette étape, mais après l'assemblage avec le substrat 750, ou bien ne jamais être formées. Les cavités 811 sont destinées à permettre l'écrasement du matériau ductile de la couche 803 pendant le scellement des cavités 751. Selon un exemple, lorsque le substrat 801 est en silicium, les procédés de gravure utilisés peuvent être des procédés de gravure de via.

La vue (d) illustre l'assemblage de la structure 814 de la vue (c) avec le substrat 750 de la vue (c) de la figure 8. Comme décrit en relation avec la figure 9, et plus particulièrement la vue (a) de la figure 9, la structure de la vue (c) est retournée, de façon à avoir sa face supérieure 815 en regard de la couche adhésive 759 du substrat 750. Comme la plaque 700, la structure 814 est positionnée au-dessus du substrat de façon que les cavités 811 sont disposées en regard de l'extrémité 757 du canal 755 débouchant sur la cavité 751, et de façon que les cavités 809 sont disposées en regard d'une autre extrémité du canal 755 destinée à être reliée à un trou de remplissage. La structure 814 et le substrat 750 sont alignés l'un en regard de l'autre avec une précision maximale de l'ordre de 1 µm.

La vue (d) illustre, en outre, le collage de la structure 814 sur le substrat 750. Le procédé de collage utilisé ici est similaire à celui présenté en relation avec la vue (a) de la figure 9.

La vue (d) illustre, en outre, la formation du trou de remplissage 817 de la chambre à vapeur. Le trou de remplissage 817 est réalisé par gravure de la portion de couche 803 présente sous la cavité 809.

Le reste du procédé de fabrication de la chambre à vapeur est similaire à celui décrit en relation avec les vues (b) à (d) de la figure 9.

Un avantage du procédé de la figure 10 est qu'il permet de réduire le nombre d'étapes de fabrication par rapport au procédé décrit en relation avec les figures 7 à 9.

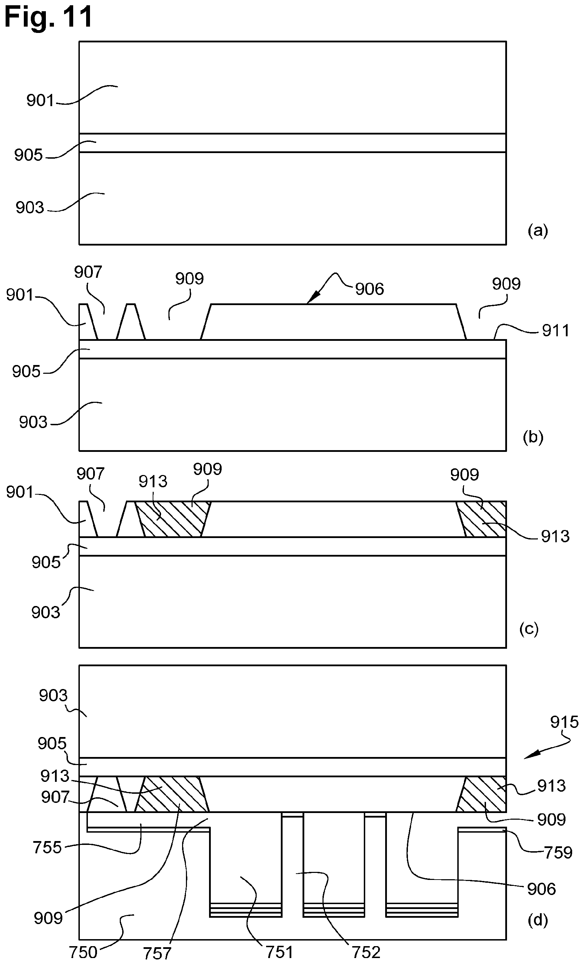

La figure 11 représente quatre vues (a), (b), (c), et (d) en coupe illustrant des étapes d'une autre variante du procédé de fabrication décrit en relation avec les figures 7 à 9. Plus particulièrement, les vues (a) à (d) illustrent une variante de mise en oeuvre du procédé de fabrication de la plaque 700 décrite en relation avec la figure 7.

La vue (a) illustre le collage temporaire d'un substrat 901 sur un substrat support 903 par l'intermédiaire d'une couche adhésive 905. Les substrats 901 et 903 sont, par exemple, en un matériau semiconducteur, par exemple, un matériau comprenant du silicium. La couche adhésive 905 est, par exemple, une couche de colle. Il s'agit d'un collage temporaire avec le même type de colle que celles utilisées en intégration 3D.

La vue (b) illustre une étape d'amincissement du substrat 901 par sa face supérieure 906. Le procédé d'amincissement est par exemple un procédé de meulage. L'épaisseur du substrat 901 peut alors être inférieure à 200 µm.

La vue (b) illustre, en outre, la gravure de cavités 907 et 909 dans le substrat 901. Sur la vue (b), une cavité 907 est représentée et deux cavités 909 sont représentées. Les cavités 907 et 909 sont gravées à partir d'une face supérieure 906 du substrat 901 et jusqu'à une face 911 supérieure de la couche 905. Les cavités 907 sont destinées à devenir des trous de remplissage, comme les cavités 704 de la figure 7 ou les cavités 809 de la figure 10. Les cavités 909 sont destinées à être remplies de matériau ductile. Les procédés de gravure utilisés sont similaires à ceux utilisés pour l'étape de gravure illustrée en relation avec la vue (a) de la figure 7.

La vue (c) illustre une étape de dépôt d'un matériau ductile 913 dans les cavités 909. Le matériau ductile 913 est du type du matériau ductile 709 décrit en relation avec la figure 7, et son procédé de dépôt dépend de sa nature. Le matériau 909 a une épaisseur, par exemple, comprise entre 20 et 100 µm. Pour que le matériau ductile 913 ne soit déposé que dans les cavités 909, le reste de la structure est, par exemple, masquée dans une étape préalable.

La vue (d) illustre l'assemblage de la structure de la vue (c) avec le substrat 750 de la vue (c) de la figure 8. Comme décrit en relation avec la figure 9, et plus particulièrement la vue (a) de la figure 9, la structure 915 de la vue (c) est retournée, de façon à avoir sa face supérieure 906 en regard de la couche adhésive 759 du substrat 750. Comme la plaque 700, la structure 915 est positionnée au-dessus du substrat de façon que les cavités 909 sont disposées en regard de l'extrémité 757 du canal 755 débouchant sur la cavité 751, et de façon que les cavités 907 sont disposées en regard d'une autre extrémité du canal 755 destinée à être reliée à un trou de remplissage. La structure 915 et le substrat 750 sont alignés l'un en regard de l'autre avec une précision maximale de l'ordre de 1 µm.

La vue (d) illustre, en outre, le collage de la structure 915 sur le substrat 750. Le procédé de collage utilisé ici est similaire à celui présenté en relation avec la vue (a) de la figure 9.

L'étape suivante du procédé de fabrication n'est pas représentée ici. Cette étape consiste en le décollage du substrat support 903 du substrat 901. Pour cela la couche de colle 905 et le substrat support 903 sont retirés, par exemple, par un traitement thermique, par un traitement UV ou alors un traitement chimique.

Comme le procédé décrit en relation avec la figure 10, un avantage du procédé de la figure 11 est qu'il permet de former une plaque d'épaisseur inférieure à 200 µm.

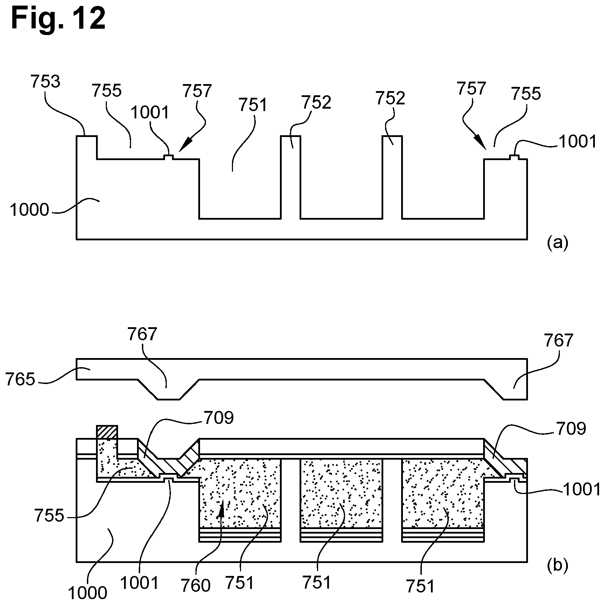

La figure 12 représente deux vues (a) et (b) en coupe illustrant des étapes d'une autre variante du procédé de fabrication décrit en relation avec les figures 7 à 9.

Plus particulièrement, les vues (a) et (b) illustrent une variante de réalisation où un substrat 1000, similaire au substrat 750 décrit en relation avec la figure 8, est associé à une plaque 700. Le substrat 1000 diffère du substrat 750 en ce qu'il comprend, en outre, des saillies 1001 disposées dans les canaux 755 de remplissage. Les substrat 1000 et 750 ayant des éléments communs, seules leurs différences seront mises en exergue.

La vue (a) illustre une étape de préparation d'un substrat 1000 similaire à l'étape illustrée en relation avec la vue (b) de la figure 8. A cette étape, le canal 755 est gravé dans le substrat 1000, et des saillies 1001 sont formées dans ce canal 755. Les saillies 1001 sont disposées au niveau des extrémités 757 du canal 755 découchant sur la cavité 751. Les saillies 1001 peuvent avoir une hauteur comprise entre 1 et 50 µm, par exemple entre 5 et 30 µm.

Selon un exemple, la gravure des saillies 1001 et du canal 755 peut être réalisée selon la succession d'étapes suivante :
- première gravure du canal jusqu'à une première profondeur P1 ;
- masquage des zones destinées à former des saillies 1001 ; et
- deuxième gravure formant le canal 755 jusqu'à une deuxième profondeur P2.

La vue (b) illustre une étape de fabrication d'une chambre à vapeur similaire à l'étape illustrée en relation avec la vue (d) de la figure 9. A cette étape, le canal 755 et la cavité 751 sont scellés par écrasement du matériau ductile 709. Les saillies 1001 étant disposées sous les portions de la plaque 700 en matériau ductile 709, le matériau 709 est écrasé sur les saillies 1001. Cette étape peut utiliser les mêmes procédés que ceux décrits en relation avec la vue (d) de la figure 9, comme, par exemple, l'utilisation du moule 765. Selon un exemple non représenté en figure 12, les reliefs 767 peuvent voir leur forme adaptée à la forme des saillies 1001.

Un avantage de ce mode de réalisation est que les saillies permettent de sceller plus efficacement les chambres à vapeur.

Un autre avantage de ce mode de réalisation est que les saillies peuvent permettre de positionner plus facilement la plaque 700 au-dessus du substrat 1000.

Les figures 13 et 14 représentent des vues (a), (b), (c), (d), (e), (f), (g), et (h) en coupe illustrant des étapes d'un mode de mise en oeuvre d'un procédé de fabrication d'un système électronique 1100.

La vue (a) de la figure 13 illustre le résultat du montage d'une puce électronique 1101 sur un substrat 1103. La puce 1101 peut comprendre un ou plusieurs composants électroniques, et/ou un ou plusieurs circuits intégrés. Selon un exemple, la puce électronique 1101 peut être un dispositif électronique adapté au domaine de la logique combinatoire, le domaine de la radiofréquence, comme les radars, la téléphonie, la technologie "5G", le domaine de l'électronique de puissance, le domaine de l'optique électronique, comme l'imagerie, la photonique, etc.

Dans l'exemple illustré en figures 13 et 14, la puce 1101 comprend au moins deux contacts 1105 disposés du côté du substrat 1103. Le substrat 1103 est destiné à être retiré en fin de procédé et a une fonction de support. Le substrat 1103 est, par exemple, en un matériau semiconducteur, par exemple, un matériau comprenant du silicium. Selon un mode de réalisation, le substrat 1103 peut être, en vue de dessus, un substrat de forme rectangulaire.

Une couche 1107 sacrificielle est formée entre la puce 1101 et le substrat 1103. Plus particulièrement, la couche 1107 repose directement sur une face supérieure 1109 du substrat 1103. La couche 1107 permet de faciliter le retrait du substrat 1103 en fin de procédé. Selon un exemple, la couche 1107 est en un polymère sensible à la température, à un traitement UV ou à un traitement chimique. Un polymère adhésif "Tape Revalapha" de la marque Nitto peut être utilisé.

Un réseau de pistes d'interconnexion 1111 est formée entre la puce 1101 et le substrat 1103. Plus particulièrement, le réseau 1111 est formé directement sur la 1107. En figure 13 et 13, le réseau 1111 est représenté par une unique couche, mais, en pratique, le réseau est constitué d'un empilement plus ou moins complexes de couches isolantes électriquement et de pistes conductrices électriquement. Les pistes conductrices sont, par exemple, des pistes métalliques, comme des pistes de cuivre.

Des bornes de connexion 1113 sont formées sur le réseau de pistes d'interconnexion 1111. Les bornes de connexion 1113 sont, par exemple, des métallisations de contact (UBM, under bump metallization). Selon un exemple, les bornes de connexion 1113 sont en un métal ou en un alliage métallique, par exemple un alliage comprenant du titane, de l'or, du titane, du chrome, ou du nickel.

Des liaisons 1115 conductrices électroniquement permettent de relier les bornes de connexion 1113 aux contacts 1105 de la puce 1101. Les liaisons 1115 sont, par exemple, des soudures, ou bien des vias.

Une couche en un matériau ductile 1117 est déposée sur toute la face supérieure de la structure. Cette couche 1117 permet une bonne tenue mécanique de l'ensemble. Le matériau ductile 1117 est similaire au matériau 709 décrit en relation avec la figure 7, à la différence que le matériau 1117 est, de plus, isolant électriquement.

La vue (b) de la figure 13 illustre une étape d'amincissement d'une partie supérieure de la structure de la vue (a). Plus particulièrement, à cette étape, la couche de matériau ductile 1117, et plus précisément une face supérieure 1119 de la couche de matériau ductile 1117, est gravée jusqu'à atteindre une face supérieure 1121 de la puce électronique 1101. Le procédé de gravure utilisé à cette étape dépend de la nature du matériau ductile 1117. Selon un exemple, le procédé de gravure peut être un procédé de meulage.

La vue (c) de la figure 13 illustre une étape de préparation d'un substrat 1200 similaire à la préparation du substrat 750 décrite en relation avec la figure 8. Ainsi, le substrat 1200 comprend une cavité 1201 destinée à recevoir un fluide de refroidissement. La cavité 1201 est formée à partir d'une face supérieure 1203 du substrat 1200. Le substrat 1200 comprend, en outre, du canal 1205 de remplissage débouchant sur la cavité 1201. Selon l'exemple représenté en figures 13 et 14, la cavité 1201 comprend deux piliers 1204 du type des piliers 651 décrits en relation avec la figure 6.

Le substrat 1200 comprend en outre une ouverture latérale 1206 destinée à former un trou de remplissage horizontal du type du trou de remplissage décrit en relation avec la vue (b) de la figure 5. L'ouverture 1206 est reliée à une extrémité du canal 1205.

La vue (d) de la figure 13 illustre une autre étape de préparation du substrat 1200 dans lequel une structure 1207 de retour par capillarité est formée dans le fond 1209 des cavités 1201. La structure 1207 est similaire à la structure 307 décrite en relation avec la figure 2. En parallèle, la structure 1207 est aussi formée sur la face 1121 de la puce électronique 1101. Cela est illustré en vue (e) .

La vue (e) de la figure 13 illustre une étape d'assemblage de la structure de la vue (b) et du substrat 1200 de la vue (d). Le substrat 1200 est retourné, de façon à ce que l'ouverture de la cavité 1201 soit en regard de la face 1121 de la puce électronique 1101. Cet assemblage est similaire à l'étape de collage décrite en relation avec la vue (a) de la figure 9. Ainsi, des couches adhésives peuvent avoir été préalablement formées sur le substrat 1200 et/ou sur la structure de la vue (b). Selon un exemple, le procédé d'assemblage peut être un collage moléculaire, un collage polymère, un collage utilisant du verre fritté, un collage par thermocompression, un collage métal-métal, etc. Selon un exemple, on peut envisager l'utilisation d'un matériau polymère, ou un collage temporaire ne résistant pas à des températures supérieures à 200 °C. Le procédé d'assemblage peut comprendre des étapes de polissage, des recuits, des mises sous pression ou sous vide.

La cavité 1201 est positionnée de façon à être en regard d'un potentiel point chaud de la puce 1101.

La vue (f) de la figure 13 illustre le retournement de la structure obtenue à la figure (e), et le retrait du substrat 1103 et de la couche sacrificielle 1109. Ce retrait peut être effectué, par exemple, par traitement thermique, par traitement UV ou par traitement chimique.

La vue (g) de la figure 14 illustre le remplissage des cavités 1201 avec un fluide de refroidissement 1150. Le fluide de refroidissement 1150 est similaire au fluide de refroidissement 319 décrit en relation avec la figure 2. Le procédé de remplissage est similaire à celui décrit en relation avec la vue (b) de la figure 9, c'est-à-dire un procédé comprenant le retrait des gaz présents dans la cavité 1201 puis le remplissage de la cavité 1201 avec le fluide 1150 de refroidissement. Le fluide 1150 est introduit par le trou de remplissage 1206, puis est dirigé par le canal 1205 dans la cavité 1201. Le trou de remplissage 1206 est ensuite bouché par un bouchon 1211.

La vue (h) de la figure 14 illustre le scellement hermétique du canal de remplissage 1205 par écrasement du matériau ductile 1117. Cette étape est similaire à l'étape de la vue (d) de la figure 9. La cavité 1201 forme alors une chambre à vapeur associée à la puce 1101.

On a représenté ici l'association d'une chambre à vapeur à une seule puce électronique. Mais il est évident pour la personne du métier que le procédé décrit en relation avec les figures 13 et 14 peut s'appliquer à la fabrication d'une chambre à vapeur commune à plusieurs puces électroniques. Il est aussi évident pour la personne du métier que le procédé décrit en relation avec les figures 13 et 14 peut s'appliquer à la fabrication de plusieurs chambres à vapeur communes à une seule puce électronique.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

En particulier, l'utilisation de saillies comme décrit en relation avec la figure 12 est compatible avec les plaques des modes de réalisation décrits en relation avec les figures 10 et 11. De même, des saillies pourraient être envisagés dans le procédé décrit en relation avec les figures 13 et 14.

Enfin, la mise en oeuvre pratique des modes de réalisation et variantes décrits est à la portée de la personne du métier à partir des indications fonctionnelles données ci-dessus.

## Revendications

1. Procédé de fabrication d'une chambre à vapeur (300) comprenant les étapes successives suivantes :
(a) graver, dans un premier substrat (301 ; 605 ; 750 ; 1000 ; 1200), au moins une première cavité (303 ; 650 ; 751 ; 1201) s'étendant à partir d'une face supérieure (305 ; 753 ; 1203) dudit premier substrat (301 ; 605 ; 750 ; 1000 ; 1200), et au moins un canal (313 ; 755 ; 1205) à partir de la face supérieure (305 ; 753 ; 1203) dudit premier substrat (301 ; 605 ; 750 ; 1000 ; 1200), une première extrémité (315 ; 757) dudit canal (313 ; 755 ; 1205) débouchant dans ladite au moins une cavité (303 ; 650 ; 751 ; 1201) ;
(b) coller une face inférieure (711) d'une plaque (309 ; 700 ; 801 ; 901) à la face supérieure (305 ; 753 ; 1203) dudit premier substrat (301 ; 605 ; 750 ; 1000 ; 1200), la plaque (309 ; 700 ; 801 ; 901) comprenant au moins une première région en un matériau ductile (321 ; 709 ; 803 ; 913 ; 1117) disposée en regard de ladite première extrémité (315 ; 757) dudit canal (313 ; 755 ; 1205) ;
(c) remplir ledit canal (313 ; 755 ; 1205) avec un fluide de refroidissement (319 ; 760 ; 1150) ; et
(d) fermer ladite cavité (303 ; 650 ; 751 ; 1201) en appliquant une pression sur ladite région en matériau ductile (321 ; 709 ; 803 ; 913 ; 1117) de la plaque (309 ; 700 ; 801 ; 901) jusqu'à obstruer ladite première extrémité (315 ; 757) dudit canal (313 ; 755 ; 1205),
dans lequel, le matériau ductile (321 ; 709 ; 803 ; 913 ; 1117) est en un matériau polymère ou en un métal comme le cuivre, de l'argent, de l'aluminium, de l'or, ou un alliage de ces métaux.

2. Procédé selon la revendication 1, dans lequel, pendant l'étape (d), ladite première cavité (303 ; 650 ; 751 ; 1201) est fermée hermétiquement.

3. Procédé selon la revendication 1 ou 2, dans lequel, le premier substrat (301 ; 605 ; 750 ; 1000 ; 1200) est en un matériau choisi dans le groupe comprenant : un matériau semiconducteur, le silicium, un métal, un alliage métallique, le verre.

4. Procédé selon l'une quelconque des revendications 1 à 3, dans lequel, pendant l'étape (a), des deuxièmes cavités (751 ; 1201) sont gravées à partir de la face supérieure (305 ; 753 ; 1203) dudit premier substrat (301 ; 605 ; 750 ; 1000 ; 1200).

5. Procédé selon la revendication 4, dans lequel ledit canal (313 ; 755 ; 1205) relie ladite première cavité (751 ; 1201) et lesdites deuxièmes cavités (751 ; 1201).

6. Procédé selon la revendication 5, dans lequel les première et deuxièmes cavités (751 ; 1201) sont reliées en série par ledit canal (313 ; 755 ; 1205).

7. Procédé selon la revendication 5, dans lequel les première et deuxièmes cavités (751 ; 1201) sont reliées en parallèle par ledit canal (313 ; 755 ; 1205).

8. Procédé selon l'une quelconque des revendications 1 à 7, dans lequel ladite plaque (309 ; 700 ; 801 ; 901) comprend une ouverture (620 ; 704 ; 809 ; 907) disposée au-dessus d'une première portion (317 ; 603) dudit canal (313 ; 755 ; 1205) .

9. Procédé selon la revendication 8, dans lequel la première portion du canal est une deuxième extrémité (317 ; 603) dudit canal (313 ; 755 ; 1205).

10. Procédé selon l'une quelconque des revendications 1 à 9, dans lequel ledit canal comprend une troisième extrémité (603) débouchant sur une ouverture (630) en périphérie du premier substrat (605).

11. Procédé selon l'une quelconque des revendications 1 à 10, comprenant, en outre, une étape (e) exécutée entre les étapes (b) et (c), pendant laquelle un quasi vide ou le vide est fait dans ladite au moins une première cavité (303 ; 751 ; 1201).

12. Procédé selon l'une quelconque des revendications 1 à 11, dans lequel, ladite première région de ladite plaque (801) s'étend sur toute la longueur de ladite plaque (801).

13. Procédé selon l'une quelconque des revendications 1 à 12, dans lequel le liquide de refroidissement (319 ; 760 ; 1150) est choisi parmi le groupe comprenant : l'eau, l'hélium, l'hydrogène, l'oxygène, l'azote, le sulfure, le néon, l'argon, le méthane, le krypton, le mercure, l'ammoniaque (NH3), l'acétone (C3H6O), l'éthane (C2H6), le pentane (C5H12), l'heptane (C7H16), l'éthanol (C2H5OH), le méthanol (CH3OH), l'éthylène glycol (C2H6O2), le toluène (C7H8), le naphtalène (C10H8), le trichlorofluorométhane (CClL3F, aussi connu sous la dénomination commerciale Fréon 11), le dichlorofluorométhane (CHClL2F, aussi connu sous la dénomination commerciale Fréon 21), le chlorodifluorométhane (CHCIF2, aussi connu sous la dénomination commerciale Fréon 22), le 1,1,2-Trichloro-1,2,2-trifluoroéthane (C2CL3F3, aussi connu sous la dénomination commerciale Freon 113), le fluide connu sous la dénomination commerciale Flutec PP2, le fluide connu sous la dénomination commerciale Flutec PP9, le fluide connu sous la dénomination commerciale Dowtherm, le fluide connu sous la dénomination commerciale Novec, et les dérivés et mélanges de ces fluides.

14. Chambre à vapeur (300) fabriquée selon le procédé selon l'une quelconque des revendications 1 à 13.
